# EUROPÄISCHE PATENTSCHRIFT

(11) **EP 0 833 444 B1**
(45) Veröffentlichungstag und Bekanntmachung des Hinweises auf die Patenterteilung: **09.11.2005**
(21) Anmeldenummer: 97114179.1
(22) Anmeldetag: 18.08.1997
(51) Int. Cl.: H03G 5/10, H03G 3/32

(54) **Verfahren und Vorrichtung zur Wiedergabe von Audiosignalen**
Method and device for reproducing audio signals
Procédé et dispositif de reproduction de signaux audio

(30) Priorität: 28.09.1996 DE 19640134
(43) Veröffentlichungstag der Anmeldung: 01.04.1998
(73) Patentinhaber: Volkswagen Aktiengesellschaft, 38436 Wolfsburg (DE)
(72) Erfinder: Beyer, Detlev, 38550 Isenbüttel (DE)
(74) Vertreter: Banzer, Hans-Jörg

(56) Entgegenhaltungen:
- US-A- 4 247 955
- US-A- 4 628 526
- US-A- 4 641 344
- US-A- 5 018 205

## Beschreibung

Die Erfindung betrifft eine Vorrichtung zur Wedergabe von Audiosignalen für ein Kraftfahrzeug, welche eine Tonhöhenregelungseinrichtung zum Erhöhen oder Erniedrigen der Verstärkung der Audiosignale in einem oder mehreren definierten Frequenzbereichen einer Frequenzkurve der Audiosignale und eine Lautstärkeregelungseinrichtung zum Erhöhen oder Erniedrigen der Verstärkung der Audiosignale in einem vollen, effektiven Frequenzbereich der Frequenzkurve der Audiosignale aufweist, wobei die Tonhöhenregelungseinrichtung die Verstärkung in den definierten Frequenzbereichen reduziert, wenn die Verstärkung der Audiosignale im vollen effektiven Frequenzbereich durch die Lautstärkeregelungseinrichtung erhöht wird, und die Tonhöhenregelungseinrichtung die Verstärkung der Audiosignale in den definierten Frequenzbereichen erhöht, wenn die Lautstärkeregelungseinrichtung die Verstärkung der Audiosignale im vollen effektiven Frequenzbereich erniedrigt, sowie ein Verfahren zur Wiedergabe von Audiosignalen, bei dem einerseits die Verstärkung der Audiosignale in einem oder mehreren definierten Frequenzbereichen einer Frequenzkurve der Audiosignale und andererseits die Verstärkung der Audiosignale in einem vollen effektiven Frequenzbereich veränderbar ist, wobei die Verstärkung in den definierten Frequenzbereichen reduziert wird, wenn die Verstärkung im vollen effektiven Frequenzbereich erhöht wird, und die Verstärkung der Audiosignale in den definierten Frequenzbereichen erhöht wird, wenn die Verstärkung der Audiosignale im vollen effektiven Frequenzbereich erniedrigt wird. Die Erfindung betrifft weiterhin ein Audiogerät für ein Kraftfahrzeug.

Verstärker zur Verwendung in Audiowiedergabesystemen besitzen Tonhöhenregelungseinrichtungen zum Ändern des Frequenzresponses der Verstärker, um dadurch die Tonhöhe des wiedergegeben Klanges einzustellen. Graphische Entzerrer werden als ein unabhängiger Schaltkreis zur Feineinstellung des Frequenzresponses und des damit verbundenen Verstärkers verwendet. Menschliche Ohren erleiden einen natürlichen Verlust der Höhenempfindlichkeit bei niedrigeren und höheren Frequenzen, wenn die Lautstärke des wiedergegebenen Klanges niedrig ist. Tonhöhenregelungseinrichtungen werden zur Kompensation einer solchen Tendenz menschlichen Gehörs durch Anheben oder Betonen hoher und niedriger Frequenzen verwendet, so daß der wiedergegebene Klang, wie er von den menschlichen Ohren gehört wird, eine scheinbar flache Frequenzcharakteristik besitzt. Bei einer Tonhöhenregelung kann die eingestellte Frequenzcharakteristik eines Audiosignals außerdem manuell durch verwenden eines Regelungsknopfes oder dergleichen eingestellt werden, hat aber nichts mit Änderungen in der Lautstärke zu tun. Daher bleibt die eingestellte Frequenzcharakteristik eines Audiosignals unverändert, unabhängig davon, ob die Lautstärke des Signals erhöht oder erniedrigt wird.

Beim Design eines Audioverstärkers wird die Verstärkung so gewählt, daß der wiedergegebene Klang nicht verzerrt wird, wenn der Lautstärkepegel maximal ist, um kräftige Eindrücke sicherzustellen, die der Zuhörer haben wird, wenn das Audiosignal mit hoher Ausgangsleistung wiedergegeben wird. Der wiedergegebene Klang wird nicht desto weniger verzerrt, wenn ein Signal zusätzlich zum erlaubten maximalen Pegel an den Verstärker angelegt wird. Ein solches zusätzliches Signal besteht zum Beispiel, wenn der Lautstärkepegel angehoben wird, während die niedrigen Frequenzen durch eine Tonhöhenregelungseinrichtung betont werden.

Aus der deutschen Offenlegungsschrift DE 40 40 769 A1 ist ein Audiowiedergabesystem zur Verwendung in einem Audioverstärker bekannt, welches eine Tonhöhenregelungseinheit zum Regeln der Tonhöhen durch Erhöhen oder Erniedrigen der Verstärkung oder durch Halten einer erhöhten oder erniedrigten Verstärkung eines Signals in einem bestimmten Frequenzbereich eines daran angelegten, wiedergegeben Audiosignals, und eine Lautstärkeregelungseinheit zum Erhöhen oder Erniedrigen der Verstärkung des Audiosignals in einem vollen, effektiven Frequenzbereich besitzt. Die Tonhöhen- und Lautstärkeregelungseinheiten sind miteinander verkoppelt, so daß die Verstärkung, die einen bestimmten Frequenzbereich durch die Tonhöhenregelungseinheit erhöht wurde in Abhängigkeit von dem Grad, mit dem die Verstärkung durch die Lautstärkeregelungseinheit erhöht wurde, geregelt werden kann. Die Tonhöhen- und Lautstärkeregelungseinheiten können jeweils variable Widerstände umfassen, deren Kontakte miteinander verbunden sind. Wenn der Knopf der Lautstärkeregelungseinheit zu einer höheren Pegelposition gedreht wird, wird die Verstärkung des Signals in dem bestimmten Frequenzbereich durch die Tonhöhenregelungseinheit verringert. Wenn der Knopf der Lautstärkeregelungseinheit zu einer niedrigeren Regelposition gedreht wird, wird die Verstärkung des Signals in dem bestimmten Frequenzbereich durch die Tonhöhenregelungseinheit erhöht.

Das in der DE 40 40 769 A1 beschriebene Audiowiedergabesystem vermeidet zwar den Nachteil bekannter Audiowiedergabesignale, daß der wiedergegebene Klang durch die Verbindung des Tonhöhenregelungspegels mit der Lautstärkeregelung nicht verzerrt wird, berücksichtigt jedoch keine Störgeräusche von außen, wie sie beispielsweise bei einem Einsatz eines Audiogerätes im Kraftfahrzeug durch die laufende Antriebsmaschine auftreten. Dadurch verändert sich das volle runde Klangbild, welches im Stand erreicht wird, während der Fahrt.

Aus der deutschen Offenlegungsschrift DE 33 22 055 A1 ist eine Schaltungsanordnung zum selbsttätigen Anpassen der Lautstärke eines Lautsprechers an einen den Lautsprecherort herrschenden Störpegel für mobile Rundfunkempfänger bekannt, der ein einstellbares Funktionsnetzwerk mit Übertragungsfunktion aufweist, welches eine Stellgröße für einen Lautstärkeregler in Abhängigkeit von dem Störgeräuschpegel derart generiert, daß der Nutzspannungspegel am Lautsprecher mit dem Störgeräuschpegel eine vorgegebene Kennlinie verknüpft ist, welche in Abhängigkeit von der Betätigung des Lautstärkestellers zumindest abschnittsweise modifizierbar ist.

Des weiteren ist in der deutschen Offenlegungsschrift DE 44 06 352 A1 eine Autoradio-Tonwiedergabeeinrichtung mit einer störgeräuschabhängigen Lautstärkesteuerung mit einer in Abhängigkeit von externen Störgeräuschen steuerbaren NF-Verstärkeranordnung beschrieben, wobei beispielsweise ein dem Drehzahlmesser eines Kraftfahrzeuges entnommenes Signal einem Mikroprozessor zugeführt wird, der einen im NF-Signalweg der Tonwiedergabeeinrichtung angeordneten Equalizer steuert. Im Mikroprozessor ist ein vorgegebenes fahrzeugbezogenes Kennlinienfeld gespeichert, mit dem in Abhängigkeit von der Motordrehzahl der NF-Frequenzgang und die Lautstärkeeinstellung verändert wird.

Weiterhin ist in der deutschen Patentschrift DE 33 15 150 C3 eine selbsttätige Lautstärke-Steuereinrichtung beschrieben, von der der Pegel des Eingangsnutzsignals und der Pegel der Nebengeräusche erfaßt werden. In einem Rechenschaltkreis werden beide Pegel einer Modifikation unterworfen. Die Verstärkung des Signalpegels des Tonsignals erfolgt nun in Überstimmung mit dem Multiplikationssignal von Eingangsnutzpegel und Nebengeräuschpegel.

Aus der US 5,018,205 A und der US 4,641,344 A ist eine Vorrichtung zur Wiedergabe von Audiosignalen in einem Kraftfahrzeug gemäß dem Oberbegriff von Anspruch 1 bzw. ein entsprechenden Verfahren gemäß dem Oberbegriff von Anspruch 12 bekannt.

Es ist die Aufgabe der Erfindung eine Vorrichtung und ein Verfahren zur Wiedergabe von Audiosignalen für ein Kraftfahrzeug zu schaffen, die neben einer automatischen Regelung der Verstärkung in definierten Frequenzbereichen in Abhängigkeit des Lautstärkepegels im vollen effektiven Frequenzbereich auch auftretende Störgeräusche in dem für den Menschen wahrnehmbaren Klangbild der Audiosignale unterdrückt

Die Aufgabe wird durch die Merkmale der Ansprüche 1 bzw. 12 gelöst. Vorteilhafte Aus- und Weiterbildungen sind in den Unteransprüchen dargestellt.

Gemäß der Erfindung wird in wenigstens einem der definierten Frequenzbereiche auf die Frequenzkurve ein zusätzlicher Verstärkungsanteil (Restloudness) aufgeschaltet und zwar in solchen Frequenzbereichen, in denen Störgeräusche auftreten. Dies geschieht bei der erfindungsgemäßen Vorrichtung vorzugsweise durch die Tonhöhenregelungseinrichtung, mit deren Hilfe manuell oder automatisch in Verbindung mit einer Lautstärkeregelung die Verstärkung der Audiosignale in definierten Frequenzbereichen veränderbar ist. Bei einem Einsatz der Vorrichtung in einem Kraftfahrzeug ist dies der Frequenzbereich, in denen durch die Antriebsmaschine verursachte Störgeräuschsignale auftreten. Die Verstärkung der Audiosignale wird im vollen effektiven Frequenzbereich in Abhängigkeit der Fahrgeschwindigkeit des Kraftfahrzeugs eingestellt.

Die Korrektur der Verstärkung in den definierten Frequenzbereichen durch Aufschaltung eines zusätzlichen Verstärkungsanteils erfolgt vorzugsweise unterhalb einer definierten Verstärkung der Audiosignale in dem vollen effektiven Frequenzbereich der Frequenzkurve, d. h. unterhalb des sogenannten Physiologiepunktes.

Gemäß einer weiteren Ausbildung der Erfindung ist der aufschaltbare Verstärkungsanteil in den definierten Frequenzbereichen bei jeder durch die Lautstärkeregelungseinrichtung erzeugten Verstärkung konstant, dabei wird für den aufschaltbaren Verstärkungsanteil ein vom Pegel der Störgeräuschsignale abhängiger Kompromißwert verwendet. Im Kraftfahrzeug hängt dieser Kompromißwert vorzugsweise vom Geräuschsignalpegel der Antriebsmaschine ab, kann also fahrzeugspezifisch festgelegt werden.

Eine andere Ausbildung der Erfindung sieht vor, daß die Störgeräuschsignale erfaßt werden und in Abhängigkeit der erfaßten Störgeräusche die definierten Frequenzbereiche, in denen eine Aufschaltung des zusätzlichen Verstärkungsanteils erfolgt, ermittelt werden. Außerdem kann in Abhängigkeit des erfaßten Störgeräuschpegels die Höhe des zusätzlichen Verstärkungsanteils festgelegt werden.

Der zusätzliche Verstärkungsanteil wird vorzugsweise bis zum Erreichen eines Klirrfaktor-Grenzwertes aufgeschaltet. Frühzeitige Verzerrungen bei hohen Verstärkungen im vollen effektiven Frequenzbereich oder ein zu frühes Ansprechen des Klirrfaktor-Grenzwertes werden durch einen frequenzabhängigen Klirrfaktor-Grenzwert, vorzugsweise im unteren NF-Bereich der Frequenzkurve verhindert.

Mit Hilfe der Erfindung wird insbesondere bei einem Audiogerät für ein Kraftfahrzeug, das beim Stillstand des Kraftfahrzeuges vorhandene volle runde Klangbild auch bei einer Bewegung des Kraftfahrzeuges, d. h. bei laufender Antriebsmaschine, erreicht.

Nachfolgend wird die Erfindung anhand eines Ausführungsbeispiels näher beschrieben. Die zugehörigen Zeichnungen zeigen:
- Figur 1: ein Blockschaltbild einer Vorrichtung zur Wiedergabe von Audiosignalen im Kraftfahrzeug,
- Figur 2: Verläufe von Frequenzkurven mit unterschiedlicher Verstärkung im vollen effektiven Frequenzbereich ohne zusätzlichen Verstärkungsanteil,
- Figur 3: Verläufe von Frequenzkurven mit unterschiedlicher Verstärkung im vollen effektiven Frequenzbereich mit zusätzlichem Verstärkungsanteil im unteren NF-Bereich und
- Figur 4: ein Verlauf des Klirrfaktor-Grenzwertes über der Frequenz.

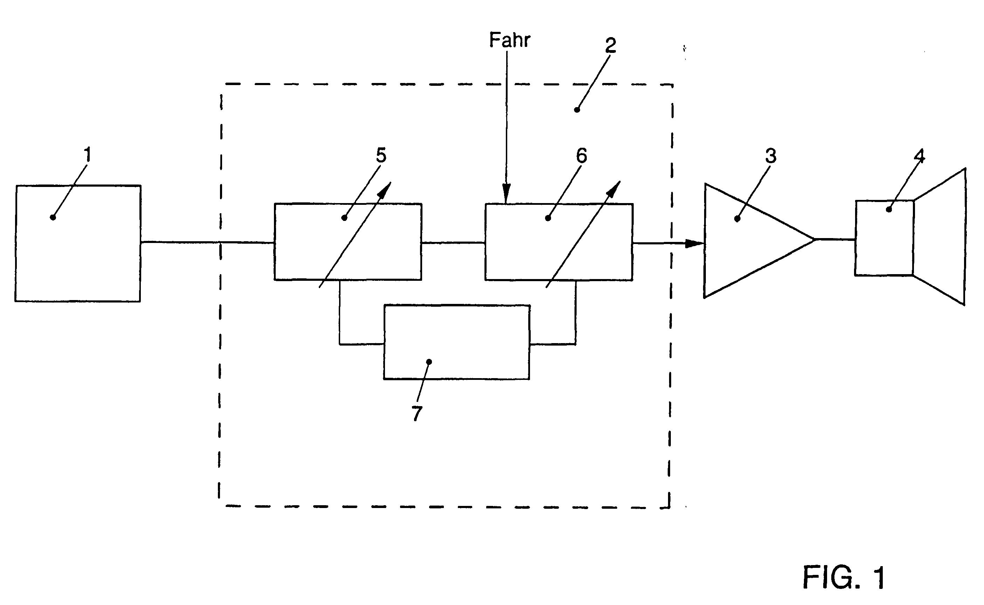

Das in Figur 1 dargestellte Blockschaltbild einer erfindungsgemäßen Vorrichtung zur Wiedergabe von Audiosignalen umfaßt eine Informationsaufnahmevorrichtung 1, eine Frequenzcharakteristikregelungseinrichtung 2, einen Verstärker 3 und einen Lautsprecher 4. Die Informationsaufnahmevorrichtung 1 ist mit der Frequenzcharakteristikregelungseinrichtung 2 verbunden und weist eine Einrichtung zum Lesen von einem Aufnahmemedium aufgenommenen Audioinformationen oder von Audioinformationen, die von einer externen Quelle zur Verfügung gestellt werden und zum Umwandeln der Audioinformationen in Audiosignale auf, die an die Frequenzcharakteristikregelungseinrichtung 2 angelegt werden. Die Informationsaufnahmevorrichtung kann eine Vorrichtung sein, wie etwa ein CD-Player, ein Kassettendeck oder dergleichen, welche die aufgenommenen Audioinformationen von einem Speichermedium lesen und die Audioinformationen in Audiosignale umwandeln. Die Informationsaufnahmevorrichtung 1 kann aber auch eine Vorrichtung zum Lesen von einer äußeren Quelle empfangenen Audioinformationen sein, wie etwa ein FM/AM-Tuner.

Die Frequenzcharakteristikregelungseinrichtung 2 ist mit dem Ausgang der Informationsaufnahmevorrichtung 1 und dem Eingang des Verstärkers 3 verbunden und regelt die Verstärkung der Audiosignale in definierten Frequenzbereichen, beispielsweise dem unteren NF-Bereich, den sogenannten Bassbereich, sowie die Verstärkung der Audiosignale im gesamten effektiven Frequenzbereich (Lautstärke). Die Audiosignale mit der geregelten Tonhöhe und Lautstärke werden von der Frequenzcharakteristikregelungseinrichtung 2 an den Verstärker 3 angelegt, welcher mit dem Lautsprecher 4 verbunden ist. Der Lautsprecher 4 wandelt die von dem Verstärker 3 erhaltenen Audiosignale in Schallwellen um und strahlt diese Schallwellen ab.

Die Frequenzcharakteristikregelungseinrichtung 2 umfaßt eine Tonhöhenregelungseinrichtung 5, eine Lautstärkeregelungseinrichtung 6 und eine Verstärkungseinrichtung 7. Die Tonhöhenregelungseinrichtung 5 verstärkt (betont) oder verringert (dämpft) die Verstärkung der Audiosignale in einem oder mehreren definierten Frequenzbereichen, beispielsweise dem unteren NF-Bereich und legt die in der Tonhöhe geregelten Audiosignale in die Lautstärkeregelungseinrichtung 6 an. Die Lautstärkeregelungseinrichtung 6 verstärkt die Audiosignale über den vollen effektiven Frequenzbereich, d. h., sie regelt die Lautstärke der Audiosignale. Sowohl die Tonhöhenregelungseinrichtung 5 als auch die Lautstärkeregelungseinrichtung 7 sind extern über einstellbare Widerstände bedienbar, wodurch einerseits die Verstärkung in den definierten Frequenzbereichen durch die Tonhöhenregelungseinrichtung 5 und andererseits die Verstärkung der Audiosignale über den vollen Frequenzbereich (Lautstärke) durch die Lautstärkeregelungseinrichtung 6 von der Bedienperson veränderbar ist. Außerdem kann die Lautstärkeregelungseinrichtung 6 in Abhängigkeit der Fahrgeschwindigkeit v_{fahr} des Kraftfahrzeuges die Verstärkung der Audiosignale über den vollen effektiven Frequenzbereich derart verändern, daß bei geringerer Fahrgeschwindigkeit die Verstärkung kleiner und bei einer hohen Fahrgeschwindigkeit größer ist.

Die Verstärkungseinrichtung 7 ist mit der Tonhöhenregelungseinrichtung 5 und der Lautstärkeregelungseinrichtung 6 verbunden. Wenn die Verstärkung über den vollen effektiven Frequenzbereich durch die Lautstärkeregelungseinrichtung erhöht wird, gibt die Verstärkungseinrichtung 7 an die Tonhöhenregelungseinrichtung eine Information, daß diese die Verstärkung in den definierten Frequenzbereichen erniedrigt. Wenn die Lautstärkeregelungseinrichtung 6 die Verstärkung über den vollen effektiven Frequenzbereich verringert, gibt die Verstärkungseinrichtung 7 eine Information zur Erhöhung der Verstärkung in den definierten Frequenzbereichen.

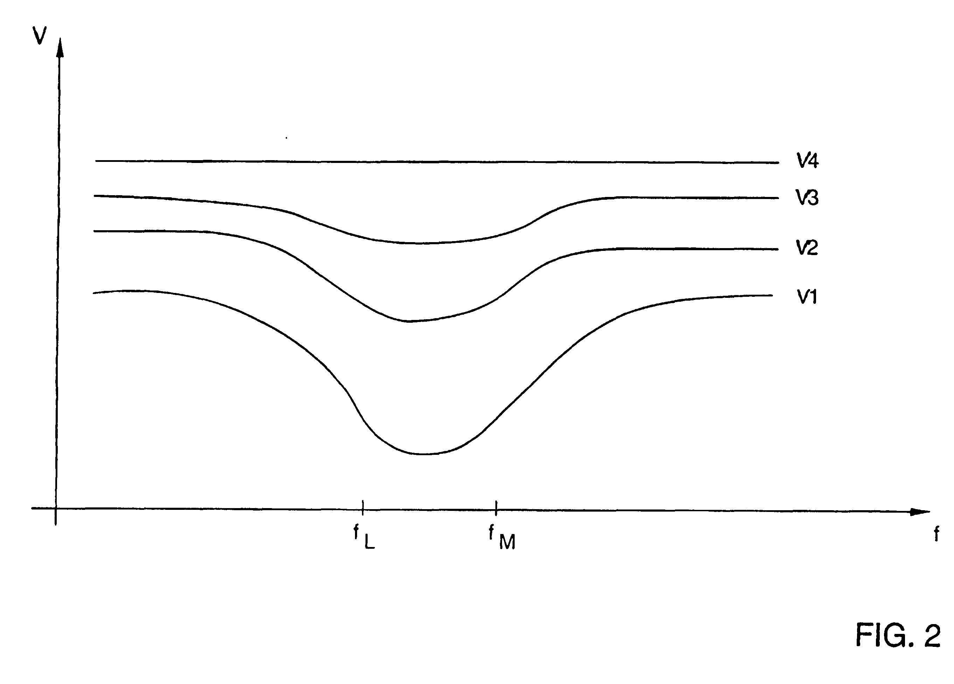

Die Verläufe der verschiedenen Frequenzkurven V(f) bei unterschiedlicher Verstärkung V1 bis V4 über den vollen effektiven Frequenzbereich f sind in Figur 2 dargestellt. Dabei ist mit f_{L} die Eckfrequenz für die Verstärkung im unteren NF-Bereich (Basspegelverstärkung) und mit f_{H} die Eckfrequenz für die Höhenverstärkung bezeichnet. Wenn die Verstärkung im vollen effektiven Frequenzbereich f von einem niedrigeren Pegel V1 zu einem höheren Pegel verschoben wird, wird der betonte Pegel der Audiosignale in den Bass- und Höhenfrequenzbereichen, der durch die Tonhöhenregelungseinrichtung bestimmt ist, verringert. Wenn die Verstärkung über den vollen effektiven Frequenzbereich f durch die Lautstärkeregelungseinrichtung verringert wird, erfolgt der oben beschriebene Prozeß umgekehrt.

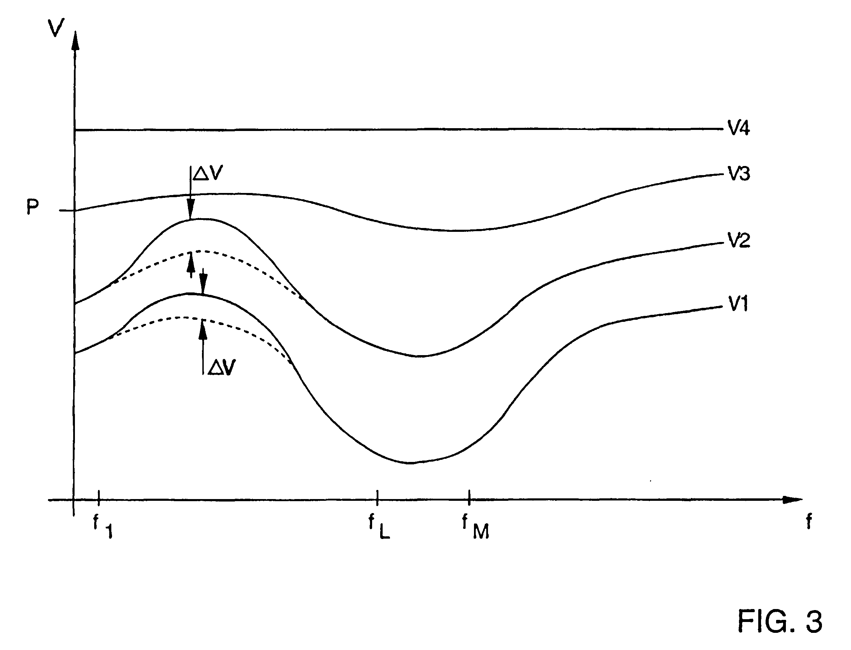

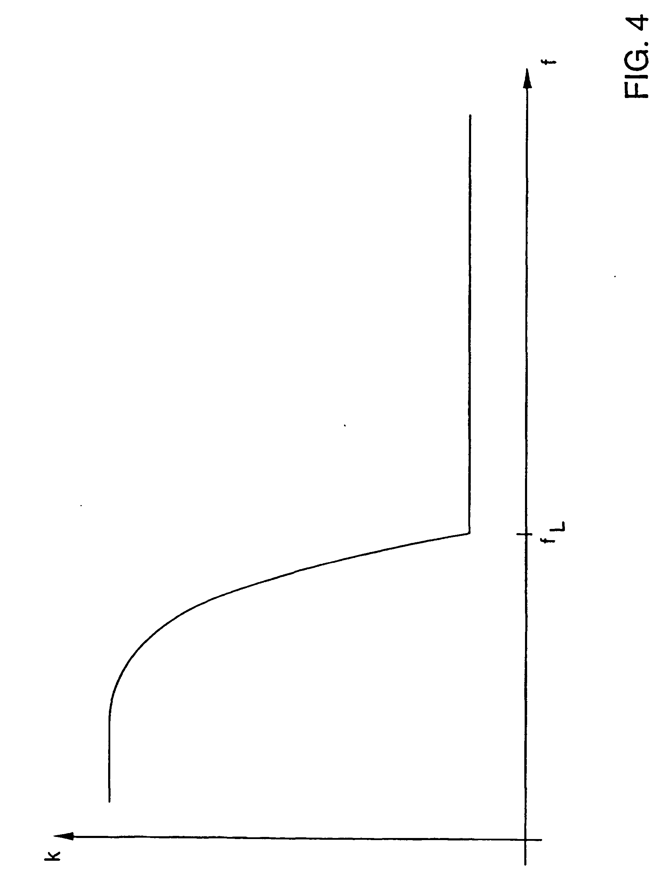

Die beschriebenen Verläufe der Verstärkungsregelung berücksichtigen jedoch bislang keine Störgeräuschsignale. Bei einem Einsatz der Wiedergabeeinrichtung in einem Audiogerät eines Kraftfahrzeuges ergibt die Verstärkungsregelung im Stand, bei nicht laufender Antriebsmaschine, ein volles rundes Klangbild, während im Fahrbetrieb, d. h. bei laufender Antriebsmaschine eine entsprechende Fülle des Klangbildes fehlt. Aus diesem Grund wird erfindungsgemäß von der Tonhöhenregelungseinrichtung 5 in dem definierten Frequenzbereich, in dem die Störgeräuschsignale auftreten, ein konstanter, zusätzlicher Verstärkungsteil ΔV unterhalb einer bestimmten Verstärkung P im vollen effektiven Frequenzbereich f der Frequenzkurve (Physiologiepunkt) aufgeschaltet, um die Störgeräuschsignale vom Menschen wahmehmenbaren Klangbild zu unterdrücken (Figur 3). Im Ausführungsbeispiel ist dies der untere NF-Bereich f₁ bis f_{L}. Der zusätzliche Verstärkungsanteil ΔV ist bis zum Erreichen des Klirrfaktor-Grenzwertes aufgeschaltet. Um frühzeitige Verzerrungen bei hohen Lautstärken und ein zu frühes Wegschalten des zusätzlichen Verstärkungsanteils ΔV zu vermeiden, ist der Klirrfaktor-Grenzwert k frequenzabhängig variabel im unteren NF-Bereich festgelegt. Der entsprechende Verlauf des Klirrfaktors k ist in Figur 4 dargestellt, wobei f_{L} die Eckfrequenz des unteren NF-Bereichs kennzeichnet.

### BEZUGSZEICHENLISTE

- 1: Informationsaufnahmevorrichtung
- 2: Frequenzcharakteristikregelungseinrichtung
- 3: Verstärker
- 4: Lautsprecher
- 5: Tonhöhenregelungseinrichtung
- 6: Lautstärkeregelungseinrichtung
- 7: Verstärkungseinrichtung

- v_{fahr}: Fahrgeschwindigkeit
- V(f): Frequenzkurve
- f_{L}, f_{M}: Eckfrequenz
- f: Frequenzbereich
- ΔV: zusätzlicher Verstärkungsanteil
- P: Physiologiepunkt
- f₁ - f_{L}: unterer NF-Bereich
- k: Klirrfaktor

## Patentansprüche

1. Vorrichtung zur Wiedergabe von Audiosignalen für ein Kraftfahrzeug, welche eine Tonhöhenregelungseinrichtung zum Erhöhen oder Erniedrigen der Verstärkung der Audiosignale in einem oder mehreren definierten Frequenzbereichen einer Frequenzkurve der Audiosignale und eine Lautstärkeregelungseinrichtung zum Erhöhen oder Erniedrigen der Verstärkung der Audiosignale in einem vollen, effektiven Frequenzbereich der Frequenzkurve der Audiosignale aufweist, wobei die Tonhöhenregelungseinrichtung die Verstärkung in den definierten Frequenzbereichen reduziert, wenn die Verstärkung der Audiosignale im vollen effektiven Frequenzbereich durch die Lautstärkeregelungseinrichtung erhöht wird, und die Tonhöhenregelungseinrichtung die Verstärkung der Audiosignale in den definierten Frequenzbereichen erhöht, wenn die Lautstärkeregelungseinrichtung die Verstärkung der Audiosignale im vollen effektiven Frequenzbereich erniedrigt, **dadurch gekennzeichnet, daß** durch die Tonhöhenregelungseinrichtung (5) in wenigstens einem der definierten Frequenzbereiche (f₁ - f_{L}) auf die Frequenzkurve (V(f)) ein zusätzlicher Verstärkungsanteil (ΔV) (Restloudness) aufschaltbar ist, in dem Störgeräuschsignale durch eine Antriebsmaschine des Kraftfahrzeugs erzeugt werden, und daß die Lautstärkeregelungseinrichtung (6) die Verstärkung der Audiosignale im vollen effektiven Frequenzbereich (f) in Abhängigkeit der Fahrgeschwindigkeit (v_{fahr}) des Kraftfahrzeuges einstellt.

2. Vorrichtung nach Anspruch 1, **dadurch gekennzeichnet, daß** unterhalb einer definierten Verstärkung (P) der Audiosignale in dem vollen effektiven Frequenzbereich (f) der Frequenzkurve (V(f)) durch die Tonhöhenregelungseinrichtung (5) in den definierten Frequenzbereichen (f₁ - f_{L}) der zusätzliche Verstärkungsanteil (ΔV) aufgeschaltet ist.

3. Vorrichtung nach einem der Ansprüche 1 bis 2. **dadurch gekennzeichnet, daß** der aufschaltbare Verstärkungsanteil (ΔV) in den definierten Frequenzbereichen (f₁ - f_{L}) bei jeder Verstärkung der Audiosignale in dem vollen effektiven Frequenzbereich (f) der Frequenzkurve (V(f)) konstant ist.

4. Vorrichtung nach einem der Ansprüche 1 bis 3. **dadurch gekennzeichnet, daß** die Höhe des zusätzlichen Verstärkungsanteils (ΔV) in Abhängigkeit des Pegels der Störgeräuschsignale festgelegt ist.

5. Vorrichtung nach Anspruch 4, **dadurch gekennzeichnet, daß** ein Meßwertaufnehmer zum Erfassen der Störgeräuschsignale vorgesehen ist, der mit der Tonhöhenregelungseinrichtung (5) verbunden ist, und die Tonhöhenregelungseinrichtung (5) die definierten Frequenzbereiche (f₁ - f_{L}), in welchen eine Aufschaltung des zusätzlichen Verstärkungsanteils (ΔV) erfolgt, und/oder die Höhe des zusätzlichen Verstärkungsanteils ermittelt.

6. Vorrichtung nach einem der Ansprüche 1 bis 5, **dadurch gekennzeichnet, daß** durch die Tonhöhenregelungseinrichtung (5) der zusätzliche Verstärkungsanteil (ΔV) bis zu einem Klirrfaktor-Grenzwert (k) aufschaltbar ist.

7. Vorrichtung nach einem der Ansprüche 1 bis 6, **dadurch gekennzeichnet, daß** einer der definierten Frequenzbereiche (f₁ - f_{L}), in denen durch die Tonhöhenregelungseinrichtung (5) der zusätzliche Verstärkungsanteil (ΔV) aufschaltbar ist, der untere NF-Bereich der Frequenzkurve (V(f)) ist.

8. Vorrichtung nach Anspruch 7, **dadurch gekennzeichnet, daß** der Klirrfaktor-Grenzwert (k) im unteren NF-Bereich variabel ist.

9. Vorrichtung nach Anspruch 8, **dadurch gekennzeichnet, daß** der Klirrfaktor-Grenzwert (k) in Abhängigkeit der Frequenz festgelegt ist.

10. Vorrichtung nach einem der Ansprüche 1 bis 9, **dadurch gekennzeichnet, daß** die Tonhöhenregelungseinrichtung (5) mit mindestens einer Bedieneinrichtung in Verbindung steht, über die die Verstärkung der Audiosignale in einem oder mehreren der definierten Frequenzbereiche manuell einstellbar ist.

11. Vorrichtung nach einem der Ansprüche 1 bis 10, **dadurch gekennzeichnet, daß** die Lautstärkeregelungseinrichtung (6) mit einer Bedieneinrichtung verbunden ist, über welche die Verstärkung der Audiosignale in dem vollen effektiven Frequenzbereich (f) der Frequenzkurve (V(f)) manuell einstellbar ist.

12. Verfahren zur Wiedergabe von Audiosignalen in einem Kraftfahrzeug, bei dem einerseits die Verstärkung der Audiosignale in einem oder mehreren definierten Frequenzbereichen einer Frequenzkurve der Audiosignale und anderseits die Verstärkung der Audiosignale In einem vollen effektiven Frequenzbereiche der Frequenzkurve veränderbar ist, wobei die Verstärkung in den definierten Frequenzbereichen reduziert wird, wenn die Verstärkung der Audiosignale im vollen effektiven Frequenzbereich erhöht wird, und die Verstärkung der Audiosignale in den definierten Frequenzbereichen erhöht wird, wenn die Verstärkung der Audiosignale im vollem effektiven Frequenzbereich erniedrigt wird, **dadurch gekennzeichnet, daß** in wenigstens einem der definierten Frequenzbereiche (f₁ - f_{L}) auf die Frequenzkurve (V(f)) ein zusätzlicher Verstärkungsanteil (ΔV) (Restloudness) geschaltet wird, in dem Störsignale durch eine Antriebsmaschine des Kraftfahrzeugs erzeugt werden, und daß die Verstärkung der Audiosignale im vollen effektiven Frequenzbereich in Abhängigkeit der Fahrgeschwindigkeit (v_{fahr}) des Kraftfahrzeugs eingestellt wird.

13. Verfahren nach Anspruch 12, **dadurch gekennzeichnet, daß** unterhalb einer definierten Verstärkung (P) der Audiosignale in dem vollen effektiven Frequenzbereich (f) der Frequenzkurve (V(f)) in den definierten Frequenzbereichen (f₁ - f_{L}) der zusätzliche Verstärkungsanteil (ΔV) aufgeschaltet wird.

14. Verfahren nach einem der Ansprüche 12 bis 13, **dadurch gekennzeichnet, daß** der aufgeschaltete Verstärkungsanteil (ΔV) in den definierten Frequenzbereichen (f₁ - f_{L}) bei jeder Verstärkung der Audiosignale in dem vollen effektiven Frequenzbereich (f) konstant ist.

15. Verfahren nach einem der Ansprüche 12 bis 14, **dadurch gekennzeichnet, daß** die Höhe des zusätzlichen Verstärkungsanteils (ΔV) in Abhängigkeit des Pegels der Störgeräuschsignale festgelegt wird.

16. Verfahren nach einem der Ansprüche 12 bis 13, **dadurch gekennzeichnet**e, daß die auftretenden Störgeräusche erfaßt werden und in Abhängigkeit der erfaßten Störgeräusche die definierten Frequenzbereiche (f₁ - f_{L}), in denen eine Aufschaltung des zusätzlichen Verstärkungsanteils (ΔV) erfolgt, und/oder die Höhe des zusätzlichen Verstärkungsanteils (ΔV) ermittelt wird.

17. Verfahren nach einem der Ansprüche 12 bis 16, **dadurch gekennzeichnet, daß** der zusätzliche Verstärkungsanteil (ΔV) bis zu einem Klirrfaktor-Grenzwert (k) aufgeschaltet wird.

18. Verfahren nach einem der Ansprüche 12 bis 17, **dadurch gekennzeichnet, daß** einer der definierten Frequenzbereiche (f₁ - f_{L}), in denen der zusätzliche Verstärkungsanteil (ΔV) aufgeschaltet wird, der untere NF-Bereich der Frequenzkurve (V(f)) ist.

19. Verfahren nach Anspruch 18, **dadurch gekennzeichnet, daß** der Klirrfaktor-Grenzwert (k) im unteren NF-Bereich variabel ist.

20. Verfahren nach Anspruch 19, **dadurch gekennzeichnet, daß** der Klirrfaktor-Grenzwert (k) in Abhängigkeit der Frequenz festgelegt wird.

## Claims

1. Device for reproducing audio signals for a motor vehicle, which has a pitch control device for increasing or decreasing the amplification of the audio signals in one or more defined frequency ranges of a frequency curve of the audio signals and a volume control device for increasing or decreasing the amplification of the audio signals in a full, effective frequency range of the frequency curve of the audio signals, the pitch control device reducing the amplification in the defined frequency ranges if the amplification of the audio signals in the full effective frequency range is increased by the volume control device, and the pitch control device increasing the amplification of the audio signals in the defined frequency ranges if the volume control device decreases the amplification of the audio signals in the full effective frequency range, **characterized in that** an additional amplification component (ΔV) (residual loudness) can be added onto the frequency curve (V(f)) in at least one of the defined frequency ranges (f₁ - f_{L}) by the pitch control device (5), **in that** noise interference signals are generated by a drive machine of the motor vehicle, and **in that** the volume control device (6) sets the amplification of the audio signals in the full effective frequency range (f) as a function of the velocity (v_{fahr}) of the motor vehicle.

2. Device according to Claim 1, **characterized in that** the additional amplification component (ΔV) is added on by the pitch control device (5) in the defined frequency ranges (f₁ - f_{L}) below a defined amplification (P) of the audio signals in the full effective frequency range (f) of the frequency curve (V(f)).

3. Device according to either Claim 1 or 2, **characterized in that** the amplification component (ΔV) which can be added on in the defined frequency ranges (f₁ - f_{L}) is constant at every amplification of the audio signals in the full effective frequency range (f) of the frequency curve (V(f)).

4. Device according to one of Claims 1 to 3, **characterized in that** the pitch of the additional amplification component (AV) is fixed as a function of the level of the noise interference signals.

5. Device according to Claim 4, **characterized in that** a measured value sensor for detecting the noise interference signals is provided, which sensor is connected to the pitch control device (5), and the pitch control device (5) determines the defined frequency ranges (f₁ - f_{L}) in which the additional amplification component (ΔV) is added on and/or the pitch of the additional amplification component.

6. Device according to one of Claims 1 to 5, **characterized in that** the additional amplification component (ΔV) can be added on by the pitch control device (5) up to a harmonic-distortion limit value (k).

7. Device according to one of Claims 1 to 6, **characterized in that** one of the defined frequency ranges (f₁ - f_{L}), in which the additional amplification component (ΔV) can be added on by the pitch control device (5), is the lower AF range of the frequency curve (V(f)).

8. Device according to Claim 7, **characterized in that** the harmonic-distortion limit value (k) is variable in the lower AF range.

9. Device according to Claim 8, **characterized in that** the harmonic-distortion limit value (k) is fixed as a function of the frequency.

10. Device according to one of Claims 1 to 9, **characterized in that** the pitch control device (5) is connected to at least one operator device by means of which the amplification of the audio signals can be adjusted manually in one or more of the defined frequency ranges.

11. Device according to one of Claims 1 to 10, **characterized in that** the volume control device (6) is connected to an operator device by means of which the amplification of the audio signals can be adjusted manually in the full effective frequency range (f) of the frequency curve (V(f)).

12. Method for reproducing audio signals in a motor vehicle, in which, on the one hand, the amplification of the audio signals in one or more defined frequency ranges of a frequency curve of the audio signals, and on the other hand, the amplification of the audio signals in a full effective frequency range of the frequency curve, can be varied, the amplification in the defined frequency ranges being reduced if the amplification of the audio signals in the full effective frequency range is increased, and the amplification of the audio signals in the defined frequency ranges being increased if the amplification of the audio signals in the full effective frequency range is decreased, **characterized in that** an additional amplification component (ΔV) (residual loudness) is added onto the frequency curve (V(f)) in at least one of the defined frequency ranges (f₁ - f_{L}), **in that** interference signals are generated by a drive machine of the motor vehicle, and **in that** the amplification of the audio signals is set in the full effective frequency range as a function of the velocity (v_{fahr}) of the motor vehicle.

13. Method according to Claim 12, **characterized in that** the additional amplification component (ΔV) is added on in the defined frequency ranges (f₁ - f_{L}) below a defined amplification (P) of the audio signals in the full effective frequency range (f) of the frequency curve (V(f)).

14. Method according to one of Claims 12 to 13, **characterized in that** the added-on amplification component (ΔV) in the defined frequency ranges (f₁ - f_{L}) is constant at every amplification of the audio signals in the full effective frequency range (f).

15. Method according to one of Claims 12 to 14, **characterized in that** the pitch of the additional amplification component (ΔV) is fixed as a function of the pitch of the noise interference signals.

16. Method according to one of Claims 12 to 13, **characterized in that** the noise interference which occurs is detected, and the defined frequency ranges (f₁ - f_{L}) in which the additional amplification component (ΔV) is added on, and/or the pitch of the additional amplification component (ΔV), are determined as a function of the detected noise interference.

17. Method according to one of Claims 12 to 16, **characterized in that** the additional amplification component (ΔV) is added on up to a harmonic-distortion limit value (k).

18. Method according to one of Claims 12 to 17, **characterized in that** one of the defined frequency ranges (f₁ - f_{L}) in which the additional amplification component (ΔV) is added on is the lower AF range of the frequency curve (V(f)).

19. Method according to Claim 18, **characterized in that** the harmonic-distortion limit value (k) is variable in the lower AF range.

20. Method according to Claim 19, **characterized in that** the harmonic-distortion limit value (k) is fixed as a function of the frequency.

## Revendications

1. Dispositif de restitution de signaux audio pour un véhicule automobile, lequel présente un dispositif de réglage de la tonalité pour augmenter ou diminuer l'amplification des signaux audio dans une ou plusieurs plages de fréquence définies d'une courbe de fréquence des signaux audio et un dispositif de réglage du volume pour augmenter ou diminuer l'amplification des signaux audio dans une plage de fréquence efficace complète de la courbe de fréquence des signaux audio, le dispositif de réglage de la tonalité réduisant l'amplification dans les plages de fréquence définies lorsque l'amplification des signaux audio est augmentée dans la plage de fréquence efficace complète par le dispositif de réglage du volume et le dispositif de réglage de la tonalité augmentant l'amplification des signaux audio dans les plages de fréquence définies lorsque le dispositif de réglage du volume diminue l'amplification des signaux audio dans la plage de fréquence efficace complète, **caractérisé en ce qu'**une part d'amplification supplémentaire (ΔV) (Restloudness) peut être activée par le dispositif de réglage de la tonalité (5) dans au moins une des plages de fréquence définies (f₁ - f_{L}) sur la courbe de fréquence (V(f)) dans laquelle des signaux parasites sont générés par un moteur d'entraînement du véhicule automobile, et que le dispositif de réglage du volume (6) règle l'amplification des signaux audio dans la plage de fréquence efficace complète (f) en fonction de la vitesse de déplacement (v_{fahr}) du véhicule automobile.

2. Dispositif selon la revendication 1, **caractérisé en ce qu'**au-dessous d'une amplification (P) définie des signaux audio dans la plage de fréquence efficace complète (f) de la courbe de fréquence (V(f)), la part d'amplification supplémentaire (ΔV) est activée par le dispositif de réglage de la tonalité (5) dans les plages de fréquence définies (f₁ - f_{L}).

3. Dispositif selon l'une des revendications 1 à 2, **caractérisé en ce que** la part d'amplification supplémentaire (ΔV) pouvant être activée dans les plages de fréquence définies (f₁ - f_{L}) est constante pour chaque amplification des signaux audio dans la plage de fréquence efficace complète (f) de la courbe de fréquence (V(f)).

4. Dispositif selon l'une des revendications 1 à 3, **caractérisé en ce que** le niveau de la part d'amplification supplémentaire (ΔV) est déterminé en fonction du niveau des signaux parasites.

5. Dispositif selon la revendication 4, **caractérisé en ce qu'**il est prévu un détecteur de valeurs mesurées pour détecter les signaux parasites, lequel est relié avec le dispositif de réglage de la tonalité (5), et le dispositif de réglage de la tonalité (5) détermine les plages de fréquence définies (f₁ - f_{L}) dans lesquelles il se produit une activation de la part d'amplification supplémentaire (ΔV), et/ou le niveau de la part d'amplification supplémentaire.

6. Dispositif selon l'une des revendications 1 à 5, **caractérisé en ce que** la part d'amplification supplémentaire (ΔV) peut être activée par le dispositif de réglage de la tonalité (5) jusqu'à une valeur limite (k) du facteur de distorsion harmonique.

7. Dispositif selon l'une des revendications 1 à 6, **caractérisé en ce que** l'une des plages de fréquence définies (f₁ - f_{L}) dans lesquelles la part d'amplification supplémentaire (ΔV) peut être activée par le dispositif de réglage de la tonalité (5) est la plage BF inférieure de la courbe de fréquence (V(f)).

8. Dispositif selon la revendication 7, **caractérisé en ce que** la valeur limite (k) du facteur de distorsion harmonique est variable dans la plage BF inférieure.

9. Dispositif selon la revendication 8, **caractérisé en ce que** la valeur limite (k) du facteur de distorsion harmonique est déterminé en fonction de la fréquence.

10. Dispositif selon l'une des revendications 1 à 9, **caractérisé en ce que** le dispositif de réglage de la tonalité (5) est relié à au moins un dispositif de commande par le biais duquel il est possible de régler manuellement l'amplification des signaux audio dans une ou plusieurs des plages de fréquence définies.

11. Dispositif selon l'une des revendications 1 à 10, **caractérisé en ce que** le dispositif de réglage du volume (6) est relié à un dispositif de commande par le biais duquel il est possible de régler manuellement l'amplification des signaux audio dans la plage de fréquence efficace complète (f) de la courbe de fréquence (V(f)).

12. Procédé de restitution de signaux audio pour un véhicule automobile, avec lequel l'amplification des signaux audio dans une ou plusieurs plages de fréquence définies d'une courbe de fréquence des signaux audio d'une part et l'amplification des signaux audio dans une plage de fréquence efficace complète de la courbe de fréquence des signaux audio d'autre part peuvent être modifiées, l'amplification dans les plages de fréquence définies étant diminuée lorsque l'amplification des signaux audio dans la plage de fréquence efficace complète est augmentée et l'amplification des signaux audio dans les plages de fréquence définies étant augmentée lorsque l'amplification des signaux audio dans la plage de fréquence efficace complète est diminuée, **caractérisé en ce qu'**une part d'amplification supplémentaire (ΔV) (Restloudness) est activée dans au moins une des plages de fréquence définies (f₁ - f_{L}) sur la courbe de fréquence (V(f)) dans laquelle des signaux parasites sont générés par un moteur d'entraînement du véhicule automobile, et que l'amplification des signaux audio dans la plage de fréquence efficace complète (f) est réglée en fonction de la vitesse de déplacement (v_{fahr}) du véhicule automobile.

13. Procédé selon la revendication 12, **caractérisé en ce qu'**au-dessous d'une amplification (P) définie des signaux audio dans la plage de fréquence efficace complète (f) de la courbe de fréquence (V(f)), la part d'amplification supplémentaire (ΔV) est activée dans les plages de fréquence définies (f₁ - f_{L}).

14. Procédé selon l'une des revendications 12 à 13, **caractérisé en ce que** la part d'amplification supplémentaire (ΔV) activée dans les plages de fréquence définies (f₁ - f_{L}) est constante pour chaque amplification des signaux audio dans la plage de fréquence efficace complète (f).

15. Procédé selon l'une des revendications 12 à 14, **caractérisé en ce que** le niveau de la part d'amplification supplémentaire (ΔV) est déterminé en fonction du niveau des signaux parasites.

16. Procédé selon l'une des revendications 12 à 13, **caractérisé en ce que** les parasites sont détectés et les plages de fréquence définies (f₁ - f_{L}) dans lesquelles il se produit une activation de la part d'amplification supplémentaire (ΔV), et/ou le niveau de la part d'amplification supplémentaire (ΔV) est déterminé en fonction des parasites détectés.

17. Procédé selon l'une des revendications 12 à 16, **caractérisé en ce que** la part d'amplification supplémentaire (ΔV) est activée jusqu'à une valeur limite (k) du facteur de distorsion harmonique.

18. Procédé selon l'une des revendications 12 à 17, **caractérisé en ce que** l'une des plages de fréquence définies (f₁ - f_{L}) dans lesquelles la part d'amplification supplémentaire (ΔV) est activée est la plage BF inférieure de la courbe de fréquence (V(f)).

19. Procédé selon la revendication 18, **caractérisé en ce que** la valeur limite (k) du facteur de distorsion harmonique est variable dans la plage BF inférieure.

20. Procédé selon la revendication 19, **caractérisé en ce que** la valeur limite (k) du facteur de distorsion harmonique est déterminé en fonction de la fréquence.
